# EUROPEAN PATENT APPLICATION

(11) **EP 4 818 110 A1**
(43) Date of publication of application: **07.10.2026**
(21) Application number: 25861731.5
(22) Date of filing: 29.04.2025
(51) Int. Cl.: B81B 7/00, B81B 7/02, B81C 1/00, B81C 3/00, G01L 11/02

(54) **VACUUM MICRO-CAVITY INTERFEROMETER CHIP AND MANUFACTURING METHOD THEREFOR, AND LOW-DRIFT OPTICAL PRESSURE SENSOR**

(30) Priority: 13.01.2025 CN 202510045540
(71) Applicant: Shanghai Baiantek Sensing Technology Co., Ltd., Shanghai 201210 (CN); Shanghai Baiantek Semiconductor Co., Ltd., Shanghai 201816 (CN)
(72) Inventor: The designation of the inventor has not yet been filed
(74) Representative: Elzaburu S.L.P.
(86) International application number: PCT/CN2025/092084
(87) International publication number: WO 2026/148754

(57) **Abstract**

Disclosed are a vacuum microcavity interferometer chip, a manufacturing method, and a low-drift optical pressure sensor. A film-island structure is formed on an upper surface of a first substrate, and includes a protruding portion and a pressure sensitive film surrounding the protruding portion, first side wall portion, getter cavity, second side wall portion, and an F-P interference cavity in the center are sequentially arranged on a lower surface of the first substrate in a radial direction, a first reflective surface is deposited on the lower surface, in the F-P interference cavity, of the first substrate, a second reflective surface is deposited on an upper surface, in the F-P interference cavity, of a second substrate, a first optical anti-reflection film is deposited on a surface of the protruding portion, and the first optical anti-reflection film, the protruding portion, the pressure sensitive film, the first reflective surface, and the second reflective surface are concentric; and the vacuum microcavity interferometer chip further includes vent hole, where the vent hole is formed in the second side wall portion for communicating the getter cavity and the F-P interference cavity.

## Description

### TECHNICAL FIELD

The present disclosure relates to sensors in the technical field of optoelectronics, in particular to a low-drift vacuum microcavity interferometer chip based on a vacuum microcavity multi-beam interferometer, a manufacturing method, and a low-drift optical pressure sensor. The sensor is mainly intended for measuring pressure signals of fluid media such as gases and liquids, and can also be applied to the measurement and control of parameters including flow rate, flow velocity, density, liquid level, altitude, and contact acting force between objects.

### BACKGROUND ART

Pressure sensors refer to devices or equipment that can sense pressure signals of fluid media such as gases and liquids, and convert the pressure signals into usable output electric or optical signals according to a predetermined rule. The pressure sensors are one of the most commonly used sensors in industrial practice, which are widely applied in various industrial automatic control environments such as water conservancy and hydropower, railway transportation, Intelligent building, production automation, aerospace, military industry, petrochemicals, oil wells, power, ships, machine tools, pipelines, etc. and also been increasingly widely applied in the fields of consumer electronics such as medical equipment, robots and automotive electronics, smart phones, smart home appliances and wearable electronic products.

The product selling price of the pressure sensors mainly depends on applicable usage conditions and measurement precision that can be maintained for a long time. Industrial-grade pressure sensors with an operating temperature range of -55°C to 85°C and a precision of 0.01%, as well as sensors with temperature resistance exceeding 200°C and 0.1% precision across the entire temperature range, each cost several thousand to tens of thousands of yuan RMB. Pressure sensors with wide temperature ranges, high precision, high reliability, and low-drift have strong demand in multiple fields such as nuclear power, aerospace, railway transportation, semiconductor equipment and process industries. The pressure sensors can be classified according to detection methods, such as electrical detection pressure sensors and optical detection pressure sensors. At present, among the electrical detection pressure sensors, resonant pressure sensors have been widely recognized by the market due to a series of advantages such as high temperature stability, high long-term stability, and high overall accuracy. However, the application of the resonant pressure sensors in high-temperature environments or occasions with radiation and electromagnetic interference is restricted. Optical fiber pressure sensors can meet the usage requirements in such occasions. An optical fiber sensing technology is a new technology that developed rapidly in the late 1970s, which is the application of fiber optics in non-communication fields. The optical fiber sensing technology can measure over a hundred types of physical quantities. It has the advantages of wide application range, high sensitivity, resistance to electromagnetic interference, good insulation, corrosion resistance, flexibility, compact size, low cost, and good compatibility with optical fiber transmission lines.

An optical fiber Fabry-Perot (F-P) pressure sensor is a type of optical fiber pressure sensor. Usually, a Fabry-Perot micro-resonant cavity is formed by an optical fiber end face and a diaphragm end face. When pressure acts on a pressure sensitive film, the pressure sensitive film deforms, resulting in a change in the cavity length of the Fabry-Perot, thereby achieving sensing and measurement. The optical fiber Fabry-Perot pressure sensor is simple in structure and easy to implement. It is the most commonly used interferometric optical fiber pressure sensor currently. Pressure sensitive films of some sensors are prepared using a micro-electromechanical system (MEMS) bulk silicon process and a surface sacrificial layer process. Pressure sensitive films of some other sensors are prepared by using an optical fiber corrosion welding process. In recent years, some design schemes have emerged. For example, Jie Zhou, Samhita Dasgupta, et al. from the University of Cincinnati developed an optical fiber Fabry-Perot pressure sensor using a bulk silicon process in 2001 (see optically interrogated MEMS pressure sensors for propulsion applications, Optical Engineering, 2001, 40:598-604.): a monocrystalline silicon film was used as a pressure sensitive film, a shallow cylindrical cavity was etched in glass with an HF buffer solution, the silicon film and the glass were tightly bonded together by an electrostatic bonding process to form a Fabry-Perot cavity, and finally, an optical fiber and a sensor chip were aligned and bonded with epoxy resin. Due to creep of the epoxy resin under the action of an external environment, the coupling angle between the optical fiber and the sensor chip will change, thereby leading to drift in a zero-point output of the sensor.

MEMS optical fiber pressure sensors combine the advantages of miniaturization, high reliability, and high consistency of an MEMS technology and the advantages of an optical fiber signal readout technology, significantly expanding the application range of high-precision pressure sensors. High-precision MEMS optical fiber sensors typically adopt wavelength demodulation methods, especially an F-P optical interference cavity (Fabry-Perot) interference type. A working principle thereof is to integrate a pressure sensitive film with an F-P optical interference cavity. The pressure sensitive film undergoes translational displacement under external pressure, the length of the F-P optical interference cavity synchronously changes, and the interference wavelength thereof also changes. The change in the wavelength is read out through an optical fiber, thereby measuring the external pressure. For specific details, please refer to the Chinese patent application CN201410728291.6 in the prior art, which discloses the measurement of pressure using an F-P optical interference cavity. This sensor has a film-island structure arranged in the F-P optical interference cavity. The inwardly oriented film-island structure increases the volume of the F-P optical interference cavity and further increases the arrangement areas of the getter film. At the same time, the inwardly oriented film-island structure has a limited height due to the spatial constraints imposed by the F-P optical interference cavity, resulting in the requirements for high light transmittance of an optical anti-reflection film arranged thereon, which increases the cost of a vacuum microcavity interferometer chip. In addition, the inwardly oriented film-island structure cannot be further processed after the sensitive chip is bonded and connected, and parameters of the vacuum microcavity interferometer chip cannot be adjusted.

Since the dynamic detection resolution of a multi-beam F-P interferometer for the cavity length can reach 1 pm to 10 pm, while the dynamic detection resolution of a dual-beam F-P interferometer for the cavity length can only reach the order of 100 pm to 1 nm, and therefore the sensitivity of the pressure sensor can be greatly improved by constructing the multi-beam F-P interferometer in the vacuum microcavity interferometer chip. However, during the construction of the multi-beam F-P interferometer, optical films need to be deposited to enhance the optical reflectivity of two reflective surfaces of the F-P interferometer. Moreover, there are extremely high requirements for the parallelism and cleanliness of the two reflective surfaces, only in this way can laser signals incident in the cavity be maintained to undergo hundreds of reflections between the two reflective surfaces, thereby meeting basic conditions of multi-wavelength interference. Due to the temperature limit of 500°C to 600°C of the optical films, the optical films of the reflective surfaces of the multi-beam F-P interferometer inside the MEMS chip can be kept intact only by adopting a silicon-glass bonding process within the temperature range of 300°C to 400°C. However, gas emitted by silicon-glass bonding can cause decrease in the vacuum degree of an interference cavity inside the multi-beam F-P interferometer and introduce unstable refractive indexes, affecting the low-pressure measurement range and zero-point stability of the MEMS pressure sensitive chip. Moreover, it will also increase the temperature coefficient and reduce the measurement repeatability. In order to achieve high-precision pressure measurement, this type of sensor usually requires vacuuming the interior of the F-P optical interference cavity, and the vacuum degree needs to keep stable. Usually, some residual gas will remain in the cavity during the manufacturing process. Therefore, it is necessary to seal a getter in the vacuum chamber and activate the getter during the manufacturing process of the sensor to absorb the residual gas in the F-P optical interference cavity, achieving high vacuum inside the pressure sensor. Chinese patent application CN20121017590.0 discloses an MEMS chip packaging structure. Usually, a getter is deposited inside an F-P optical interference cavity by physical vapor deposition (PVD). To ensure that the residual gas is absorbed completely, the getter usually occupies a relatively large area. Therefore, when the range of the sensor is increased by reducing the area of the pressure sensitive film, the limitation imposed by the getter area becomes a constraining factor. In addition, the getter is of a porous structure, with poor density. When the getter is heated or vibrated externally, particles will be generated, which will contaminate the F-P optical interference cavity and potentially lead to spectral deterioration, greatly affecting the measurement of the optical sensor, especially causing device failure in severe cases. Chinese patent application CN201410264998.6 relates to a hybrid wafer-level vacuum packaging method. Getter cavity is formed in a side of a chip packaging cavity and communicated through vent hole, and cover is fixed after a getter is fixed to the getter cavity. This structure and method also have the potential for the getter to contaminate an F-P optical interference cavity. Moreover, in this method, the getter cavity and getter are superimposed after a chip is formed, such that the manufacturing process is complex. Moreover, there is a certain possibility that getter particles enter a working cavity through vent hole passages. The getter particles have a certain insulating property and have a relatively small impact on electrical detection sensors.

In addition, after an MEMS pressure sensitive chip and an optical fiber are coupled and packaged into an MEMS optical pressure module, secondary packaging is usually required for fixing the module to a pressure sensor housing, so as to achieve sealed pressure extraction, module measurement, isolation and protection of an outgoing cable and become an MEMS optical pressure sensor that can be independently mounted and used. During secondary packaging of a structure of a sensitive chip recited in CN201410728291.6, a multi-beam F-P interferometer will be subjected to uneven stress whether external mechanical force on a housing is conducted to the MEMS pressure-sensitive chip or to a welding and packaging position between the MEMS pressure sensitive chip and an optical fiber, resulting in the deterioration of an interference spectrum, measured values will change abnormally, and meanwhile a zero-point output of the sensor will drift.

Industrial pressure sensors are difficult to maintain and calibrate or high in cost in addition to the high requirements for precision, such that it is usually required that the pressure sensors have the characteristic of low drift, including long-term high stability at a zero point and low-temperature drift. Compared with traditional electrical pressure sensors (such as piezoresistive types), MEMS optical fiber sensors inherently exhibit higher zero-point stability due to the absence of resistor thermal noise and other influences. In the present disclosure, a sensor chip and a housing are welded by welding a second substrate and the housing, which greatly reduces the influences of residual stress and thermal expansion and contraction of the housing and welding flux on a sensitive film and an optical fiber collimator of a pressure sensor, and can effectively improve the zero-point stability of the pressure sensor. The approximate symmetry of a first substrate and a third substrate with respect to the second substrate also significantly reduces the change in an output of the sensor caused by the temperature change, i.e., the low-temperature drift. Without adding additional temperature measurement elements for digital temperature compensation, the change in the thermal drift output in a full temperature range of -55°C to 125°C can be less than 1% of the change in the full-range pressure output of the sensor.

### SUMMARY

The present disclosure provides a vacuum microcavity interferometer chip, a manufacturing method, and a low-drift optical pressure sensor in order to overcome the technical defects of optical fiber pressure sensors in the prior art. The vacuum microcavity interferometer chip includes a first substrate, a second substrate, and a third substrate, where the first substrate and the third substrate may be silicon substrates or silicon nitride wafers or other substrates with similar functions, the second substrate may be a glass wafer or a sapphire wafer or a substrate with similar functions, and the three substrates are bonded and fixedly connected through silicon-glass-silicon bonding or corresponding dielectric layers, such as benzocyclobutene (BCB) glue, gold layers or glass paste. A film-island structure is formed on an upper surface of the first substrate, and the film-island structure includes a protruding portion formed by a counterbored hole and a pressure sensitive film surrounding the protruding portion; a first side wall portion, a getter cavity, a second side wall portion, and an F-P interference cavity are sequentially arranged on a lower surface of the first substrate in a radial direction, wherein the F-P interference cavity is located at the center of the lower surface of the first substrate; a first reflective surface is deposited on the lower surface, in the F-P interference cavity, of the first substrate; a second reflective surface is deposited on an upper surface, in the F-P interference cavity, of the second substrate; a first optical anti-reflection film is deposited on a surface of the protruding portion; the first optical anti-reflection film, the protruding portion, the pressure sensitive film, the first reflective surface, and the second reflective surface are concentric; a mounting hole for an optical fiber collimator is formed in the center of the third substrate; a getter film is arranged on at least one surface in the getter cavity; and the vacuum microcavity interferometer chip further includes a vent hole, where the vent hole is formed in the second side wall portion for communicating the getter cavity and the F-P interference cavity. The upper surface of the first substrate is a pressure bearing side. By orienting the film-island structure toward the pressure bearing side, an optical path can be increased by increasing a thickness of the protruding portion by means of a high refractive index of silicon of the protruding portion, to attenuate light penetrating through the first reflective surface, thereby reducing the process difficulty of the optical anti-reflection film deposited on the surface of the protruding portion and the requirements for light transmittance of the optical anti-reflection film, better eliminating the influences of disturbance of multi-interface reflected light for the F-P interference cavity, achieving more excellent spectral characteristics of the multi-beam F-P interference cavity, and reducing pressure monitoring disturbance of the vacuum microcavity interferometer chip. In a case where a semi-reflection demodulation method is adopted, the reflectivity of the first reflective surface is set as non-total reflection, which is less than 50%, and more than 50% of light will be transmitted into the protruding portion from the first reflective surface. In a case where the thickness of the protruding portion is small, this part of transmitted light is less attenuated, it is necessary to set the first optical anti-reflection film at higher light transmittance, or even at the light transmittance of 99% accordingly, and the requirements for the process and cost of the first optical anti-reflection film are high. Meanwhile, by orienting film-island structure toward the pressure bearing side, the total volume of the F-P interference cavity can be reduced, so as to reduce the area of the required getter film; and meanwhile, after the three layers of substrates are bonded, geometric dimensions of the protruding portion and the pressure sensitive film of the film-island structure and a border on an outer side of the pressure sensitive film are selectively processed, thereby flexibly adjusting the sensitivity of the vacuum microcavity interferometer chip. By means of the above structure, the getter cavity is connected with the F-P interference cavity through the vent hole, the getter cavity can be independently arranged, it is ensured that the getter cavity has enough surface area to absorb residual gas in the F-P optical interference cavity, and it is also ensured that the area of the pressure sensitive film can be flexibly adjusted, for example, the area of the pressure sensitive film can be minimized during large-range pressure measurement.

In a preferred embodiment, the vent hole is formed in the second side wall portion, the second side wall portion has first height, and preferably, the vent hole is formed at a middle position of the first height of the second side wall portion, and communicates the getter cavity and the F-P interference cavity. A small quantity of particles will be generated after the getter film is activated, and the particles cannot penetrate through the vent hole along with vibration of the sensor to reach the F-P interference cavity by arranging the vent hole at the middle height position of the second side wall portion, thereby being prevented from contaminating an optical film in the F-P interference cavity to lead to chip failure.

In a further preferred embodiment, the getter cavity is an annular cavity, such that the maximum body surface area of the getter cavity is provided, and the area of the getter film is increased.

In a further preferred embodiment, the vent hole is formed at the bottom of the second side wall portion, the vent hole can be processed through etching, and the vent hole, the getter cavity, and the F-P interference cavity can be processed in a same step.

In a preferred embodiment, the protruding portion of the first substrate is of a cylindrical structure, and the pressure sensitive film has a circular area. This structure is conducive to achieving uniform force bearing in fluid media such as gas and liquid, the high-pressure bearing capacity of the chip is improved, and the stability of interference spectra between the two reflective surfaces of the F-P interference cavity within the vacuum microcavity interferometer chip under the action of pressure is improved.

In a preferred embodiment, the first substrate and the third substrate have the same diameter and the same thickness, thereby forming a structure approximately symmetric with respect to the second substrate. Since the first substrate and the third substrate are both silicon wafers, silicon nitride or other substrates, and have the same coefficient of thermal expansion, the three layers of substrates have good stress matching characteristics, the whole vacuum microcavity interferometer chip can have an extremely low temperature coefficient, bending deformation of a center of the vacuum microcavity interferometer chip is reduced, and it is ensured that the two reflective surfaces of the F-P optical interference cavity under the action of full-range pressure are kept relatively parallel, which is conducive to achieving high stability of a zero-point output of the vacuum microcavity interferometer chip through good stress matching, thereby forming the characteristics of high zero-point long-term stability (capable of being kept at 0.1% of the full range for 15 years) and low temperature drift (without adding additional temperature measurement elements for digital temperature compensation, the change in a thermal drift output in a full temperature range of -55°C to 125°C can be less than 1% of the change in the full-range pressure output of the sensor).

In a preferred embodiment, the second substrate has a dimension larger than that of the first substrate and the third substrate. Therefore, when a sensor is manufactured using the vacuum microcavity interferometer chip, an exposed surface is formed because the outer dimension of the second substrate is larger than that of the first substrate and the third substrate. The exposed surface is adhesively bonded or welded and fixed to a sensor housing, such that the first substrate, the third substrate, and the optical fiber collimator are not in contact with the sensor housing, thereby achieving stress isolation among the film-island structure of the vacuum microcavity interferometer chip, the optical fiber collimator on the third substrate, and the sensor housing. When the sensor housing is subject to force or vibration, the force or vibration will be directly transmitted to the second substrate, and due to the approximately symmetric structure in which the first substrate and the third substrate are disposed on two sides of the second substrate, the first substrate and the third substrate will vibrate as an integrated unit, and no stress is applied to the film-island structure and the optical fiber collimator on the third substrate, thereby ensuring no change in the zero-point output of the vacuum microcavity interferometer chip before and after fastened mounting of machinery on site or during external force impact and forming the characteristics of high zero-point long-term stability and low temperature drift.

In a preferred embodiment, the getter film is deposited on a surface, namely a lower surface, of the second substrate within the getter cavity and/or on a surface, namely the upper surface, of the first substrate, within the getter cavity; a notch groove is formed in the first side wall portion and the second side wall portion, located at positions where the first side wall portion and the second side wall portion are bonded to the second substrate, and the notch groove communicates with the getter cavity. The notch groove is an annular groove. A small quantity of particles will be generated when the getter film is activated, and the particles can be stored in the notch groove when the sensor is subject to inclining or vibration. The particles freely moving in the getter cavity are further reduced, such that the possibility of the particles entering the F-P interference cavity through the vent hole is reduced.

The present application further relates to a low-drift optical pressure sensor, including a sensor housing and a sensitive chip mounting seat arranged in the sensor housing. The vacuum microcavity interferometer chip is fixed only through the second substrate in contact with the sensitive chip mounting seat. By means of the structure, stress isolation among the film-island structure of the vacuum microcavity interferometer chip, the optical fiber collimator on the third substrate, and the sensor housing is achieved. When the sensor housing is subject to force or vibration, the force or vibration will be directly transmitted to the second substrate; and due to the approximately symmetric structure in which the first substrate and the third substrate are disposed on two sides of the second substrate, the first substrate and the third substrate will vibrate as an integrated unit, and no stress is applied to the film-island structure and the optical fiber collimator on the third substrate, thereby ensuring no change of the zero-point output of the vacuum microcavity interferometer chip before and after fastened mounting of machinery on site or during external force impact.

The present application further relates to a manufacturing method of the MEMS vacuum microcavity interferometer chip. A first substrate is selected as a silicon-on-insulator (SOI) silicon wafer (three-layer structure of top silicon-buried oxygen layer-bottom silicon). The manufacturing method includes the steps: S1. A getter cavity, an F-P interference cavity, and a vent hole communicating the getter cavity and the F-P interference cavity are formed in one surface of the first substrate through an etching and/or potassium hydroxide (KOH) etching process; and a first reflective surface is deposited on a surface of the F-P interference cavity; a film-island structure is formed on the other surface of the first substrate through etching and/or KOH etching, and the film-island structure comprises a protruding portion and a pressure sensitive film surrounding the protruding portion; a surface of a protruding portion is an original polished surface, the protruding portion has the same thickness with the border of the first substrate, and a first optical anti-reflection film is deposited on the protruding portion; S2. a second reflective surface is deposited at a position, corresponding to the F-P interference cavity, of one surface of a second substrate (double-surface-polished glass wafer), and a getter film is deposited at a position, corresponding to the getter cavity, of the same surface of the second substrate, wherein the getter film and the second reflective surface are located on the same side of the second substrate; a second optical anti-reflection film is deposited at a position, corresponding to the mounting hole, of the other surface of the second substrate; S3. the mounting hole for an optical fiber collimator is manufactured in a third substrate (ultraflat double-surface-polished silicon wafer); a counterbored hole is formed in a surface, facing the second substrate, of the third substrate, where the area of the counterbored hole is greater than that of the second optical anti-reflection film, thereby preventing the second optical anti-reflection film from affecting the bonding quality of the second substrate and the third substrate; and S4. the first substrate, the second substrate, and the third substrate are bonded through a three-layer bonding technology at a bonding temperature of 300°C-400°C, where since a getter usually needs to be thermally activated after being deposited, an activation temperature is usually 300°C or above, and the getter film can be activated at the same time of bonding, thereby eliminating the need to activate the getter film after device manufacturing; and the bonding temperature of silicon-glass-silicon is usually selected to be less than 400°C, or the three substrates are bonded at a temperature less than 400°C by selecting corresponding dielectric layers, such that it can be ensured that an optical film with temperature resistance of more than 500°C manufactured after deposition of an optical dielectric material in the chip is not affected.

In a further preferred embodiment, the manufacturing method further includes a step S5, after the three layers of substrates are bonded, a protruding portion and a pressure sensitive film of a film-island structure are selectively processed under control based on real-time measurement of thicknesses of respective monocrystalline silicon thereof. Geometric dimensions of the protruding portion and the pressure sensitive film of the film-island structure and the border on the outer side of the pressure sensitive film can be selectively processed, thereby flexibly adjusting the sensitivity of the vacuum microcavity interferometer chip.

The present disclosure aims to provide the vacuum microcavity interferometer chip, the manufacturing method, and the low-drift optical pressure sensor. By separating the multi-beam F-P interference cavity for pressure sensitivity and detection from the getter cavity within the vacuum microcavity interferometer chip and connecting both through the vent hole, the area of the pressure sensitive film and the area of the getter can be independently adjusted according to requirements, and the situation that activated getter particles enter the F-P interference cavity, affecting the reliability of the vacuum microcavity interferometer chip is avoided through corresponding structures. The exposed surface is formed based on that the second substrate of the MEMS vacuum microcavity interferometer chip is larger than the first substrate and the third substrate in outer dimension, or adhesion or welded fixation with the sensor housing is achieved through a glass protective tube, the first substrate, the third substrate, and the optical fiber collimator are not connected with the sensor housing through welding flux or adhesives, and therefore stress isolation among the sensitive structure and the optical fiber collimator of the MEMS vacuum microcavity interferometer chip, and a packaging position and the pressure sensor housing of the chip is achieved. The chip is of a three-layer bonding structure, and a plurality of structures and materials such as the pressure sensitive film, the F-P interference cavity, and the getter are integrated and miniaturized. The getter film is activated in the bonding process, the manufacturing process of the sensor is simplified, and the getter film is activated without independently consuming energy. By orienting the film-island structure toward the pressure bearing side, the thickness of the F-P interference cavity can be reduced, so as to reduce the volume thereof and air therein, and reduce the area of the getter film; and meanwhile, after the three layers of substrates are bonded, geometric dimensions of the protruding portion and the pressure sensitive film of the film-island structure and the border on the outer side of the pressure sensitive film can be selectively processed, thereby flexibly adjusting the sensitivity of the vacuum microcavity interferometer chip.

### BRIEF DESCRIPTION OF THE DRAWINGS

FIG. 1 is a schematic structural diagram of an MEMS vacuum microcavity interferometer chip according to the present application;
FIG. 2 is a schematic structural diagram of a top face of a first substrate;
FIG. 3 is a schematic structural diagram of another embodiment.
FIG. 4 is a schematic structural diagram of a bottom face of a first substrate in FIG. 3;
FIG. 5 is a schematic structural diagram of a pressure sensor; and
FIG. 6 is a schematic diagram of a partial structure in FIG. 5.

### Brief description of reference signs:

1-first substrate; 11-protruding portion; 111-first optical anti-reflection film; 112-first reflective surface; 113-second reflective surface, 114-second optical anti-reflection film; 12-pressure sensitive film; 13-first side wall portion; 14-getter cavity; 141-notch groove; 142-vent hole; 15-second side wall portion; 16-F-P interference cavity; 2-second substrate; 3-third substrate; 31-optical fiber collimator; 32-mounting hole; 4-sensor housing; and 5-sensitive chip mounting seat.

### DETAILED DESCRIPTION OF THE EMBODIMENTS

In order to more clearly explain the embodiments of the present disclosure or the technical solutions of the prior art, the drawings needed in the description of the embodiments or the prior art will be briefly described below. Apparently, the drawings in the following description are merely some embodiments of the present disclosure. For those ordinarily skilled in the art, other drawings can be obtained in accordance with these drawings without involving any inventive effort.

For the sake of simplicity of the drawings, the portions relevant to the present disclosure are shown only schematically in the drawings, which do not represent the actual structures thereof as a product. Additionally, in order to simplify the drawings for ease of understanding, components having the same structure or function in some drawings are shown schematically with only one of them, or only one of them is labeled. Herein, "a" means not only "only this one" but also "more than one" case.

It should also be understood that the term "and/or" used in the specification and the appended claims of the present application means any combination of one or more of associated listed items and all possible combinations, and includes these combinations.

Here, it needs to be noted that unless otherwise clearly specified and limited, terms "disposed", "coupled", and "connected" should be broadly understood. For example, the terms may refer to fixed connection, detachable connection or integrated connection; the terms may refer to mechanical connection or electric connection; and the terms may refer to direct connection, indirect connection through an intermediate medium, or communication between interiors of two elements. For a person of ordinary skill in the art, the specific meaning of the above terms in the present disclosure can be understood according to specific circumstances.

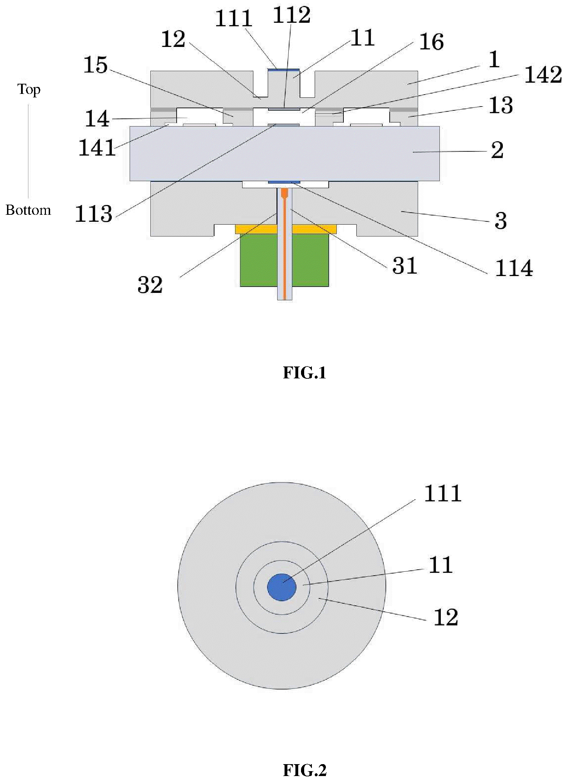

The present disclosure provides a vacuum microcavity interferometer chip, a manufacturing method, and a low-drift optical pressure sensor in order to overcome the technical defects of optical fiber pressure sensors in the prior art. The vacuum microcavity interferometer chip includes a first substrate 1, a second substrate 2, and a third substrate 3, where the first substrate 1 and the third substrate 3 are silicon substrates, the second substrate 2 is a glass wafer, and the three substrates are connected through bonding. A film-island structure is formed on an upper surface of the first substrate 1, as shown in FIG. 1. The film-island structure includes a protruding portion 11 formed by a counterbored hole and a pressure sensitive film 12 surrounding the protruding portion 11, first side wall portion 13, getter cavity 14, second side wall portion 15, and an F-P interference cavity 16 are sequentially arranged on a lower surface of the first substrate 1 in a radial direction, wherein the F-P interference cavity is located at the center of the lower surface of the first substrate; a first reflective surface 112 is deposited on the lower surface, in the F-P interference cavity 16, of the first substrate 1; a second reflective surface 113 is deposited on an upper surface, in the F-P interference cavity 16, of the second substrate 2; a first optical anti-reflection film 111 is deposited on a surface of the protruding portion 11; the first optical anti-reflection film 111, the protruding portion 11, the pressure sensitive film 12, the first reflective surface 112, and the second reflective surface 113 are concentric; a mounting hole 32 for an optical fiber collimator 31 is formed in the center of the third substrate 3; a getter film is arranged on at least one surface in the getter cavity 14; and the vacuum microcavity interferometer chip includes a vent hole 142, where the vent hole 142 is formed in the second side wall portion 15 for communicating the getter cavity 14 and the F-P interference cavity 16. The upper surface of the first substrate 1 is a pressure bearing side. By orienting the film-island structure toward the pressure bearing side, an optical path can be increased by increasing a thickness of the protruding portion 11 by means of a high refractive index of silicon of the protruding portion 11, to attenuate light penetrating through the first reflective surface 112, thereby reducing the process difficulty of the optical anti-reflection film deposited on the surface of the protruding portion 11 and the requirements for light transmittance of the optical anti-reflection film, better eliminating the influences of disturbance of multi-interface reflected light for the F-P interference cavity 16, achieving more excellent spectral characteristics of the multi-beam F-P interference cavity 16, and improving pressure monitoring sensitivity of the vacuum microcavity interferometer chip. In a case where a semi-reflection demodulation method is adopted, the reflectivity of the first reflective surface 112 is set as non-total reflection, which is less than 50%, and more than 50% of light will be transmitted into the protruding portion 11 from the first reflective surface 112. In a case where the thickness of the protruding portion 11 is small, this part of transmitted light is less attenuated, it is necessary to set the first optical anti-reflection film 111 at higher light transmittance, or even at the light transmittance of 99% accordingly, and the requirements for the process and cost of the first optical anti-reflection film 111 are high. Meanwhile, by orienting the film-island structure toward the pressure bearing side, the thickness of the F-P interference cavity 16 can be reduced, so as to reduce the volume thereof and air therein, and reduce the area of the getter film; and meanwhile, after the three layers of substrates are bonded, geometric dimensions of the protruding portion and the pressure sensitive film 12 of the film-island structure and a border on an outer side of the pressure sensitive film 12 can be selectively processed, as shown in FIG. 2, thereby flexibly adjusting the sensitivity of the vacuum microcavity interferometer chip. By means of the above structure, the getter cavity 14 is connected with the F-P interference cavity 16 through the vent hole 142, the getter cavity 14 can be independently arranged, it is ensured that the getter cavity 14 has enough surface area to absorb residual gas in the F-P optical interference cavity, and it is also ensured that the area of the pressure sensitive film 12 is small enough during high-pressure measurement, meeting the requirements for corresponding measurement sensitivity.

In a preferred embodiment, the at least one vent hole 142 is formed in the second side wall portion 15, the second side wall portion 15 has first height, and preferably, the vent hole 142 is formed at a middle height position of the second side wall portion 15, and communicates the getter cavity 14 and the F-P interference cavity 16. A small quantity of particles will be generated after the getter film is activated, and the particles cannot penetrate through the vent hole 142 along with vibration of the sensor to reach the F-P interference cavity 16 by arranging the vent hole 142 at the middle height position of the second side wall portion 15. This prevents the influence on the F-P interference cavity 16, thereby preventing inaccurate measurement.

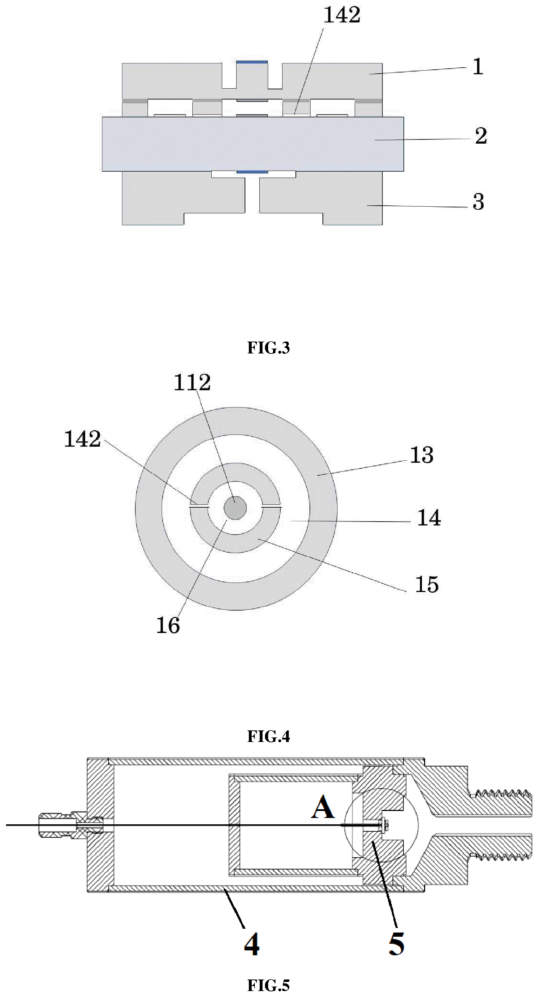

In a further preferred embodiment, the vent holes 142 may further be formed at the bottom of the second side wall portion 15, as shown in FIG. 3 and FIG. 4. The vent holes 142 can be processed through etching, and the vent holes, the getter cavity, and the F-P interference cavity 16 can be formed in the same processing step during processing, so as to improve the processing efficiency of the vent holes.

In a further preferred embodiment, the getter cavity 14 is an annular cavity, such that the maximum body surface area of the getter cavity 14 is provided, and the area of the getter films is increased.

In a preferred embodiment, the protruding portion 11 is of a cylindrical structure, and the pressure sensitive film 12 has a circular area. This structure is conducive to achieving uniform force bearing in fluid media such as gas and liquid, the high-pressure bearing capacity of the chip is improved, and the stability of interference spectra between the two reflective surfaces of the F-P interference cavity 16 in the vacuum microcavity interferometer chip under the action of pressure is improved.

In a preferred embodiment, the first substrate 1 and the third substrate 3 have the same diameter and the same thickness, thereby forming a structure approximately symmetric with respect to the second substrate. Since the first substrate 1 and the third substrate 3 are both silicon wafers and have the same coefficient of thermal expansion, the three layers of substrates have good stress matching characteristics, the whole vacuum microcavity interferometer chip can have an extremely low temperature coefficient, bending deformation of a center of the vacuum microcavity interferometer chip is reduced, and it is ensured that the two reflective surfaces of the F-P optical interference cavity under the action of full-range pressure are kept relatively parallel, which is conducive to achieving high stability of a zero-point output of the vacuum microcavity interferometer chip through good stress matching.

In a preferred embodiment, the second substrate 2 has a dimension larger than that of the first substrate 1 and the third substrate 3, and the dimension of the second substrate may be parameters such as length or diameter, which depends on the shape of the second substrate. Therefore, when a low-drift optical pressure sensor is manufactured by using the vacuum microcavity interferometer chip, an exposed surface is formed because the outer dimension of the second substrate 2 is larger than that of the first substrate 1 and the third substrate 3. The exposed surface is adhesively bonded or welded and fixed to a sensor housing, such that the first substrate 1, the third substrate 3, and the optical fiber collimator 31 are not in contact with the sensor housing. Stress isolation among the film-island structure of the vacuum microcavity interferometer chip, the optical fiber collimator 31 on the third substrate 3, and the sensor housing is achieved, and when the sensor housing is subject to force or vibration, the force or vibration will be directly transmitted to the second substrate 2, and due to the approximately symmetric structure in which the first substrate 1 and the third substrate 3 are disposed on two sides of the second substrate 2, the first substrate 1 and the third substrate 3 will vibrate as an integrated unit, and no stress is applied to the film-island structure and the optical fiber collimator 31 on the third substrate 3, thereby ensuring no change in the zero-point output of the vacuum microcavity interferometer chip before and after fastened mounting of machinery on site or during external force impact.

In a preferred embodiment, the getter film is deposited on a surface, namely a lower surface, in the getter cavity 14, of the second substrate 2 and/or on a surface, namely the upper surface, in the getter cavity, of the first substrate 1; a notch groove 141 is formed in the first side wall portion 13 and the second side wall portion 15, located at positions where the first side wall portion 13 and the second side wall portion 15 are bonded to the second substrate 2, and the notch groove 141 communicates with the getter cavity 14. A small quantity of particles will be generated when the getter film is activated, and the particles can be stored in the notch groove 141 when the sensor is subject to inclining or vibration. The particles freely moving in the getter cavity 14 are further reduced, such that the possibility that the particles enter the F-P interference cavity 16 through the vent hole 142 is reduced.

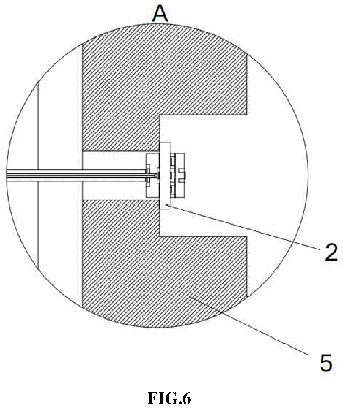

The present application further relates to a low-drift optical pressure sensor, including a sensor housing 4 and a sensitive chip mounting seat 5 arranged in the sensor housing, as shown in FIG. 4 and FIG. 5. As shown in FIG. 5 and FIG. 6, the vacuum microcavity interferometer chip is fixed only through the second substrate 2 in contact with the sensitive chip mounting seat 5. By means of the structure, stress isolation among the film-island structure of the vacuum microcavity interferometer chip, the optical fiber collimator 31 on the third substrate 3, and the sensor housing is achieved. When the sensor housing is subject to force or vibration, the force or vibration will be directly transmitted to the second substrate 2; and due to the approximately symmetric structure in which the first substrate 1 and the third substrate 3 are disposed on two sides of the second substrate 2, the first substrate 1 and the third substrate 3 will vibrate as an integrated unit, and no stress is applied to the film-island structure and the optical fiber collimator 31 on the third substrate 3, thereby ensuring no change of the zero-point output of the vacuum microcavity interferometer chip before and after fastened mounting of machinery on site or during external force impact.

The present application further relates to a manufacturing method of the MEMS vacuum microcavity interferometer chip. A first substrate 1 is selected as an SOI silicon wafer (three-layer structure of top silicon-buried oxygen layer-bottom silicon). The manufacturing method includes the steps: S1. A getter cavity 14, an F-P interference cavity 16, and a vent hole 142 communicating the getter cavity 14 and the F-P interference cavity 16 are formed in one surface of the first substrate 1 through an etching and/or KOH etching process; and a first reflective surface 112 is deposited on a surface of the F-P interference cavity 16; a film-island structure is formed on the other surface of the first substrate 1 through etching and/or KOH etching, and the film-island structure comprises a protruding portion and a pressure sensitive film surrounding the protruding portion; a surface of a protruding portion 11 is an original polished surface, the protruding portion has the same thickness with the border of the first substrate, and a first optical anti-reflection film 111 is deposited on the protruding portion 11; etching the film-island structure on the other surface of the first substrate is not necessary, this step may also be omitted, and the film-island structure may be formed in subsequent steps; S2. a second reflective surface 113 is deposited at a position, corresponding to the F-P interference cavity 16, of one surface of a second substrate 2 (double-surface-polished glass wafer), and a getter film is deposited at a position, corresponding to the getter cavity 14, of the same surface of the second substrate, wherein the getter film and the second reflective surface 113 are located on the same side of the second substrate 2; a second optical anti-reflection film 114 is deposited at a position, corresponding to a mounting hole 32, of the other surface of the second substrate 2; S3. the mounting hole 32 for an optical fiber collimator 31 is manufactured in a third substrate 3 (ultraflat double-surface-polished silicon wafer); a counterbored hole is formed in a surface, facing the second substrate 2, of the third substrate 3, where the area of the counterbored hole is greater than that of the second optical anti-reflection film 114, thereby preventing the second optical anti-reflection film 114 from affecting the bonding quality of the second substrate 2 and the third substrate 3; and S4. the first substrate 1, the second substrate 2, and the third substrate 3 are bonded through a three-layer bonding technology at a bonding temperature of 300°C-400°C, where since a getter usually needs to be thermally activated after being deposited, an activation temperature is usually 300°C or above, and the getter film can be activated at the same time of bonding, thereby eliminating the need to activate the getter film after device manufacturing; and the bonding temperature of silicon-glass-silicon is usually selected to be less than 400°C, or the three substrates are bonded at a temperature less than 400°C by selecting corresponding dielectric layers, such that it can be ensured that an optical film with temperature resistance of more than 500°C manufactured after deposition of an optical dielectric material in the chip is not affected.

In a further preferred embodiment, the manufacturing method further includes a step S5, where after the three layers of substrates are bonded, a protruding portion 11 and a pressure sensitive film 12 of a film-island structure are selectively processed under control based on real-time measurement of thicknesses of respective monocrystalline silicon thereof. Geometric dimensions of the protruding portion and the pressure sensitive film 12 of the film-island structure and the border on the outer side of the pressure sensitive film 12 can be selectively processed, thereby flexibly adjusting the sensitivity of the vacuum microcavity interferometer chip.

## Claims

1. A vacuum microcavity interferometer chip, comprising a first substrate, a second substrate, and a third substrate, wherein the three substrates are bonded together; **characterized in that**:
a film-island structure is formed on an upper surface of the first substrate, and the film-island structure comprises a protruding portion and a pressure sensitive film surrounding the protruding portion;
a first side wall portion, a getter cavity, a second side wall portion, and an F-P interference cavity are sequentially arranged on a lower surface of the first substrate in a radial direction, wherein the F-P interference cavity is located at the center of the lower surface of the first substrate;
a first reflective surface is deposited on the lower surface, in the F-P interference cavity, of the first substrate;
a second reflective surface is deposited on an upper surface, in the F-P interference cavity, of the second substrate;
a first optical anti-reflection film is deposited on a surface of the protruding portion;
the first optical anti-reflection film, the protruding portion, the pressure sensitive film, the first reflective surface, and the second reflective surface are concentric;
a mounting hole for an optical fiber collimator is formed in the center of the third substrate;
a getter film is arranged on at least one surface of the getter cavity; and
the chip further comprises at least one vent hole formed in the second side wall portion for communicating the getter cavity and the F-P interference cavity.

2. The vacuum microcavity interferometer chip according to claim 1, **characterized in that** the vent hole is formed in the second side wall portion, the second side wall portion has a first height, and the vent hole is formed at a middle position of the first height of the second side wall portion.

3. The vacuum microcavity interferometer chip according to claim 1 or 2, **characterized in that** the getter cavity is an annular cavity.

4. The vacuum microcavity interferometer chip according to claim 1 or 2, **characterized in that** the vent hole is formed at the bottom of the second side wall portion, and the vent hole, the getter cavity, and the F-P interference cavity are formed in the same processing step during processing.

5. The vacuum microcavity interferometer chip according to claim 1 or 2, **characterized in that** the protruding portion is of a cylindrical structure, and the pressure sensitive film has a circular area.

6. The vacuum microcavity interferometer chip according to claim 1 or 2, **characterized in that** the first substrate and the third substrate have the same diameter and the same thickness, thereby forming a structure approximately symmetric with respect to the second substrate.

7. The vacuum microcavity interferometer chip according to claim 1 or 2, **characterized in that** a diameter of the second substrate is greater than that of the first substrate and the third substrate; an exposed surface is formed because an outer dimension of the second substrate is larger than that of the first substrate and the third substrate; and the exposed surface is adhesively bonded or welded and fixed to a sensor housing, such that the first substrate, the third substrate, and the optical fiber collimator are not in contact with the sensor housing.

8. The vacuum microcavity interferometer chip according to claim 1 or 2, **characterized in that** the getter film is deposited on a surface, namely a lower surface, of the second substrate within the getter cavity and/or on a surface, namely an upper surface, of the first substrate, within the getter cavity; and a notch groove is formed in the first side wall portion and the second side wall portion at positions where the first side wall portion and the second side wall portion are bonded to the second substrate, and the notch groove communicates with the getter cavity.

9. A low-drift optical pressure sensor, **characterized by** comprising a sensor housing and a sensitive chip mounting seat arranged in the sensor housing, wherein the vacuum microcavity interferometer chip according to any one of claims 1-8 is fixed only through the second substrate in contact with the sensitive chip mounting seat.

10. A manufacturing method of the vacuum microcavity interferometer chip according to any one of claims 1-8, **characterized by** comprising the following steps: S1. forming a getter cavity, an F-P interference cavity, and a vent hole communicating the getter cavity and the F-P interference cavity in one surface of a first substrate, and depositing a first reflective surface on a surface of the F-P interference cavity; S2. depositing a second reflective surface at a position, corresponding to the F-P interference cavity, of one surface of a second substrate, and depositing a getter film at a position, corresponding to the getter cavity, of the same surface of the second substrate, wherein the getter film and the second reflective surface are located on a same side of the second substrate; depositing a second optical anti-reflection film at a position, corresponding to the mounting hole, of the other surface of the second substrate; S3. forming the mounting hole for the optical fiber collimator in a third substrate; forming a counterbored hole in a surface of the third substrate facing the second substrate, wherein the area of the counterbored hole is greater than that of the second optical anti-reflection film; and S4. bonding the first substrate, the second substrate, and the third substrate through a three-layer bonding technology at a controlled bonding temperature of 300°C-400°C.

11. According to the manufacturing method in claim 10, **characterized by** further comprising a step S5, after the three-layer bonding of the substrates, measuring thicknesses of the protruding portion and the pressure sensitive film of the film-island structure in real time, and selectively processing the protruding portion and the pressure sensitive film under control.
